(19) Europäisches Patentamt

European Patent Office

Office européen des brevets

(11) **EP 1 657 822 A1**

(12) **EUROPEAN PATENT APPLICATION**

(43) Date of publication:
**17.05.2006 Bulletin 2006/20**

(51) Int Cl.:
*H03L 7/20* (2006.01)     *H03B 21/02* (2006.01)

(21) Application number: **04292694.9**

(22) Date of filing: **10.11.2004**

(84) Designated Contracting States:
**AT BE BG CH CY CZ DE DK EE ES FI FR GB GR HU IE IS IT LI LU MC NL PL PT RO SE SI SK TR**
Designated Extension States:
**AL HR LT LV MK YU**

(71) Applicant: **ALCATEL**
**75008 Paris (FR)**

(72) Inventor: **Gris, Marco**
**20142 Milano (IT)**

(74) Representative: **Sciaux, Edmond et al**
**COMPAGNIE FINANCIERE ALCATEL**
**Département Propriété Industrielle**
**54, rue La Boétie**
**75008 Paris (FR)**

(54) **Frequency comb generator for synthesizers**

(57) A circuit arrangement and a method for obtaining a signal for use in downconverting a signal of a relatively high frequency VCO (7). A pulse train ($S_1$) is generated as a function of a reference signal which is then fed into an oscillator (2) so as to generate a signal ($S_2$) modulated by said pulse train ($S_1$). The resulting signal is fed into a band pass filter (4) which in turn outputs a selected frequency band ($S_3$) to be mixed with the signal of VCO (7) in order to obtain the down converted control signal for phase locking.

$S_1$

$S_2$      $S_3$

Fig. 3

EP 1 657 822 A1

**Description**

The present invention relates to the field of microwave digital radio communications and more particularly it relates to a circuit arrangement used in synthesizers for down-converting the signal of a voltage controlled oscillator (VCO) to a frequency suitable for comparison with a reference frequency and thereby extracting the locking control signal for locking the phase of a local signal to that of a received signal.

## BACKGROUND OF THE INVENTION

A typical synthesizer has a general construction based on a master oscillator of fixed frequency for producing oscillations of adjustable frequency and of high stability and accuracy, by combination, filtering and interpolation effected on oscillations from frequency multipliers and frequency dividers. VCOs are commonly used in synthesizer in order to provide the desired oscillations. A VCO, as is well known in the art, is an oscillator the frequency of which is determined as a function of the voltage of an input signal provided thereto.

In complex synthesizers, *i.e.* synthesizers that are not single loop, complex procedures are required in order to down-convert the frequency of the signal generated by the VCO so as to be compared with a reference frequency and thereby extract a locking control signal.

Among known topologies and techniques used to this end, one example is that of using a sampler, the latter being a circuit that samples the signal of the VCO with a high quality reference signal shaped in narrow pulses. This signal has a broad band spectrum of equally spaced lines that when multiplied with the VCO signal, produces a down converted replica of the VCO suitable for locking in a PLL circuit. In order to perform this conversion the $n^{th}$ harmonic of the sampling signal is needed, where n may be a high integer, for example in the range of 100 to 200 or even higher.

However, it is difficult to perform this operation at relatively high frequencies of the signal generated by the VCO - for example between 10 and 20 GHz - in particular when the reference signal frequency is in the range of 100 MHz. As a remedy, certain techniques are used to produce harmonics of the reference signal at such high frequencies. However such approaches suffer from poor efficiency and/or instability because they require the use of very high harmonics (integer n is very high, in the range of 1000). This in turn requires very strong nonlinear circuits with the drawback that their constant performances may be affected by parasitic reactances and losses that urge to decrease the level of harmonics at high frequencies.

Therefore, it is desirable to implement a circuit for sampling the VCO in its operating range having characteristics of stability and good efficiency to be used in very high performance synthesizers.

Some known solutions to achieve this objective comprise, for instance, the use of FET samplers driven on the gate by the reference signal, or the use of mixers driven by a step recovery diode.

However, these known solutions suffer from instability and limitation on band, whereas what is desired is to provide samplers that can cover all the frequency ranges used in this technique and to down-convert and sample every signal up to the maximum usable frequency.

In order to achieve this purpose ideal impulses would be needed. Nevertheless, such ideal impulses cannot be produced by real-life circuits; in fact even if the highest quality circuits known in practice are used, still small parasitic reactances may cause limitation in the bandwidth and the efficiency.

These limitations become particularly more evident when a relatively high frequency VCO (10-20 GHz) is used, because electrical parameter variations due to temperature changes, bias conditions and device parameter dispersion tend to limit the efficiency of the frequency conversion.

For example at 10 GHz frequency of VCO, the 100th harmonic is needed if a 100 MHz reference signal is to be used. In this example, the spacing is of 100 MHz. However, should a finer spacing be used, for instance 10 MHz, then at 10 GHz the 1000th harmonic must be generated.

However, the generation efficiency of these harmonics decreases with the order of the harmonics in accordance with the following known relationship.

$$Y = \left| SIN(X)/X \right|.$$

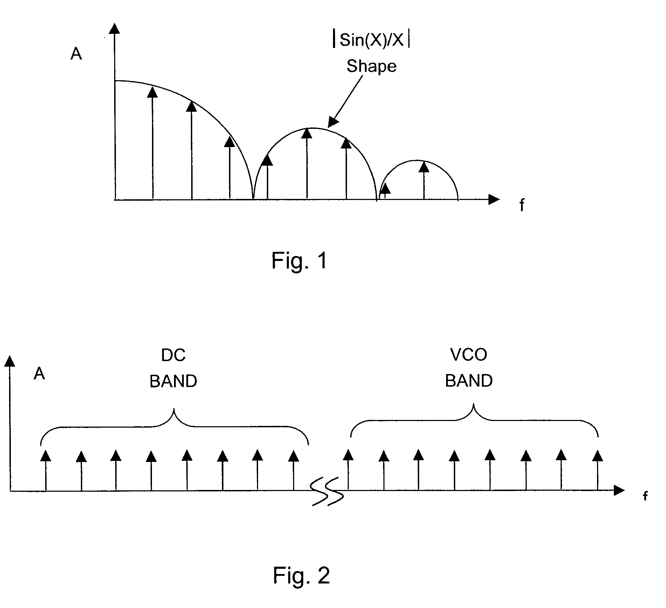

A typical shape spectrum based on this relationship is shown in figure 1. in this figure, the X axis represents the frequencies of the harmonic and the Y axis represents the amplitude A of the harmonics. As shown in this figure, as higher harmonics (frequencies) are generated, the efficiency of the generated signal decreases. Clearly, these known solutions also lack a satisfactory performance and hence a different circuit arrangement is desired.

The ideal solution would be the design of the true "universal" sampler with a flat constant spectrum as shown in figure 2. While it is clear that such a design is impossible because of its "ideal" nature, any attempt towards approaching as close as possible to the ideal spectrum could be directed to overcoming the above drawbacks and this is the purpose of the solution proposed by the present invention.

## DESCRIPTION OF THE INVENTION

The above objective is achieved by means of the solution proposed by the present invention according to which a pulse train is fed into an oscillator in order to obtain a modulated signal with a relatively high frequency to be used, as a sampler, for the down-conversion of the RF VCO signal at the relatively high frequency. The choice of the frequency of the oscillator is related to the frequency of the RF VCO. The suitable frequency band as used by the RF VCO is selected from the modulated signal using a band pass filter. This resulting signal is mixed with the signal of the RF VCO and the down converted control signal is thus obtained for the purpose of phase locking.

Accordingly one object of the present invention is that of providing a circuit arrangement for down-converting a signal of a relatively high frequency VCO in a synthesizer comprising:

- a pulse generator, driven by a reference signal, for generating a pulse train,
- an oscillator for receiving the pulse train and generating a signal modulated with said pulse train, and
- a band pass filter for outputting a frequency band from the modulated signal generated by the oscillator.

According to an aspect of the invention, the circuit arrangement further comprises a mixer for mixing the output of the filter with a signal of the relatively high frequency VCO, for obtaining a down-converted signal.

According to another aspect of the invention, the relative high frequency is in the range of 10 to 20 GHz.

According to a further aspect of the invention, the circuit arrangement further comprises a frequency multiplier, for further multiplying a frequency range of the pulse generator.

Another object of the present invention is that of providing a synthesizer comprising the circuit arrangement of the invention.

Yet another object of the present invention is that of providing a receiver including the circuit arrangement or the synthesizer of the invention.

Still another object of the present invention is that of providing a method for obtaining a signal for use in down-converting a signal of a relatively high frequency VCO comprising the steps of:

- generating a pulse train by means of a pulse generator driven by a reference signal,
- receiving the pulse train and generating a signal modulated by said pulse train by means of an oscillator, and
- outputting a frequency band from the modulated signal by means of a band pass filter.

These and further features and advantages of the present invention are explained in more detail in the following description as well as in the claims with the aid of the accompanying drawings.

BRIEF DESCRIPTION OF THE DRAWINGS

Figure 1 is a representation of a typical spectrum of a signal as a function of harmonics thereof as is known in the art.

Figure 2 is a representation of an ideal situation where sampling signals are generated having constant spectrum at different frequencies.

Figure 3 shows a block diagram of a circuit arrangement for generating a frequency comb for synthesizers according to the present invention.

EXAMPLE OF A PREFERRED EMBODIMENT

As stated above, it is desired to obtain a circuit arrangement for sampling the signal generated by a VCO in its operating range having characteristics of stability and good efficiency to be used in very high performance synthesizers.

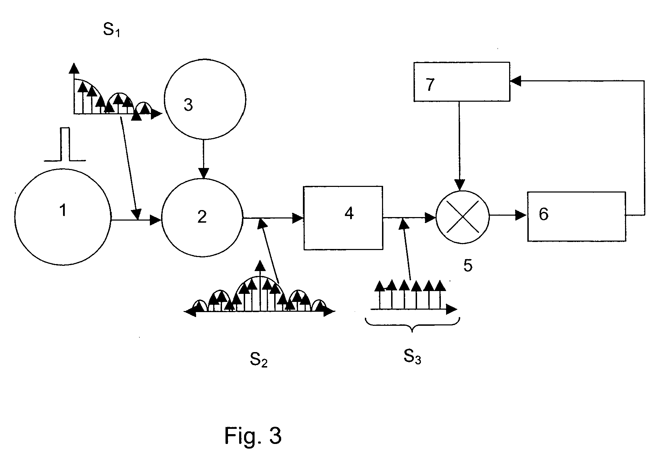

Figure 3 shows an example of such circuit arrangement according to the present invention. The circuit arrangement comprises a pulse generator 1, an oscillator 2, a band pass filter 4 and a mixer 5. The circuit may optionally further comprise a frequency multiplier, not shown, in case of need for example to further extend the frequency range of the pulse generator. Further elements shown in figure 3 are a power supply 3, a loop filter 6 for locking and spur reduction and an RF VCO 7 disposed, in a loop arrangement with an output thereof provided to the mixer 5. The operation of these elements are well known to those skilled in the art and therefore no description in this respect is considered necessary.

The block diagram of figure 3 may be functionally described as follows:

The oscillator must be of a type having very low phase noise, insensitive to microphonic vibrations and stable. A suitable type of oscillator having these characteristics may be a Surface Acoustic Wave (SAW) oscillator known in the related art.

It is to be noted that the pulse generator 1 is a circuit driven by the reference signal. its frequency determines the spacing of the harmonics. On the other hand, the maximum order of the harmonic generated is limited by the duration of the pulse. The narrower the pulse (less duration), the higher will be the order of the maximum harmonic. This follows from the relationship:

$$A = \mathrm{Sin}(\tau)/\tau$$

where $\tau$, is the duration of the pulse and A is the amplitude envelope of the spectrum of the pulse train. By decreasing $\tau$ the amplitude envelope of the pulse train approaches 1, the frequency approaching from DC to high frequency as an ideal train of pulses. Therefore, very narrow pulses mean very fast circuits limited by uncontrolled parasitic reactances which constitute a very important limiting factor.

If a pulse train $S_1$ is fed into the oscillator 2 as proposed by the present invention, the resulting signal $S_2$ output from the oscillator 2 is in this manner modulated by the pulse train $S_1$ and thus the conversion of the signal at higher frequency may be obtained by using said modulated signal.

The choice of the frequency of the oscillator 2 is dependent upon the frequency of the RF VCO 7.

Next the resulting signal $S_2$ is fed into a band pass filter 4 in order to select the proper frequency band used by the RF VCO 7 and eliminate other undesired frequencies.

This resulting filtered signal $S_3$ is mixed in mixer 5 with the signal of the VCO 7 and thus the desired down converted control signal is obtained for use in the phase locking operation as is known in the art.

The solution proposed by the present invention provides a very stable and affordable circuit because the impulses of the pulse train do not need to have a very short duration, therefore can easily be generated with conventional available circuits. Hence they are more amplitude stable and are not conditioned by reactive parameters of the circuits.

Another advantage of the proposed circuit arrangement is that the sampling operation is done by means of a stable and easily controlled signal strictly in the required bandwidth without the limitations suffered at high frequencies as explained above.

As a result, the solution proposed by the invention allows for the sampling of the VCO signal with a stable and reliable circuit. This circuit is thus useful in high quality synthesizers because of its satisfactory performances.

**Claims**

1. A circuit arrangement for down-converting a signal of a relatively high frequency VCO (7) in a synthesizer comprising:

   - a pulse generator (1), driven by a reference signal, for generating a pulse train ($S_1$),
   - an oscillator (2) for receiving the pulse train ($S_1$) and generating a signal modulated with said pulse train ($S_2$), and
   - a band pass filter (4) for outputting a frequency band ($S_3$) from the modulated signal ($S_2$) generated by the oscillator.

2. A circuit arrangement according claim 1 further comprising a mixer (5) for mixing the output ($S_3$) of the

filter (4) with a signal of the relatively high frequency VCO (7), for obtaining a down-converted signal.

3. A circuit according to claim 1 or 2 wherein the relative high frequency is in the range of 10 to 20 GHz.

4. A circuit arrangement according to any one of claims 1-3 further comprising a frequency multiplier, for further multiplying a frequency range of the pulse train generated by the pulse generator (1).

5. A synthesizer comprising the circuit arrangement of claim 1 for down-converting a signal of a relatively high frequency VCO (7) in the synthesizer wherein the circuit arrangement comprises:

   - a pulse generator (1), driven by a reference signal, for generating a pulse train ($S_1$),
   - an oscillator (2) for receiving the pulse train ($S_1$) and generating a signal modulated with said pulse train ($S_2$), and
   - a band pass filter (4) for outputting a frequency band ($S_3$) from the modulated signal ($S_2$) generated by the oscillator.

6. A receiver including the circuit arrangement of claim 1 or the synthesizer of claim 5.

7. A method for obtaining a signal for use in down-converting a signal of a relatively high frequency VCO (7) comprising the steps of:

   - generating a pulse train ($S_1$) by means of a pulse generator driven by a reference signal,
   - receiving the pulse train ($S_1$) and generating a signal ($S_2$) modulated by said pulse train ($S_1$) by means of an oscillator (2), and
   - outputting a frequency band ($S_3$) from the modulated signal ($S_2$) by means of a band pass filter (4).

A

|Sin(X)/X|
Shape

f

Fig. 1

A

DC
BAND

VCO
BAND

f

Fig. 2

Fig. 3

**European Patent Office**

**EUROPEAN SEARCH REPORT**

Application Number

EP 04 29 2694

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 367 546 A (GTE LABORATORIES INCORPORATED) 9 May 1990 (1990-05-09) * column 4, lines 1-27; figure 1 * | 1-7 | H03L7/20 H03B21/02 |
| X | US 3 902 132 A (FRIED ET AL) 26 August 1975 (1975-08-26) * column 5, line 42 - column 7, line 29; figure 6 * | 1-7 | |
| X | US 3 641 434 A (LESTER R. YATES ET AL) 8 February 1972 (1972-02-08) * column 3, line 74 - column 4, line 29; figure 2 * | 1-7 | |
| X | GB 2 163 019 A (* MICROWAVE ASSOCIATES LTD) 12 February 1986 (1986-02-12) * page 2, line 129 - page 3, line 54; figure 4 * | 1-7 | |
| A | US 6 005 446 A (GALANI ET AL) 21 December 1999 (1999-12-21) * column 4, lines 40-60 * | 1-7 | TECHNICAL FIELDS SEARCHED (Int.Cl.7) |
| A | US 4 728 906 A (TURL ET AL) 1 March 1988 (1988-03-01) * column 8, lines 6-25; figure 7 * | 1-7 | H03L H03B |

The present search report has been drawn up for all claims

| Place of search | Date of completion of the search | Examiner |
|---|---|---|
| Munich | 6 April 2005 | Gerdes, R |

EPO FORM 1503 03.82 (P04C01)

## ANNEX TO THE EUROPEAN SEARCH REPORT
## ON EUROPEAN PATENT APPLICATION NO.

EP 04 29 2694

This annex lists the patent family members relating to the patent documents cited in the above-mentioned European search report.
The members are as contained in the European Patent Office EDP file on
The European Patent Office is in no way liable for these particulars which are merely given for the purpose of information.

06-04-2005

| Patent document cited in search report | | Publication date | Patent family member(s) | | Publication date |
|---|---|---|---|---|---|
| EP 0367546 | A | 09-05-1990 | US | 5016242 A | 14-05-1991 |
| | | | CA | 2001511 A1 | 01-05-1990 |
| | | | EP | 0367546 A2 | 09-05-1990 |
| | | | JP | 2213240 A | 24-08-1990 |
| US 3902132 | A | 26-08-1975 | NONE | | |
| US 3641434 | A | 08-02-1972 | DE | 1950137 A1 | 16-04-1970 |
| | | | FR | 2020308 A5 | 10-07-1970 |
| | | | GB | 1233324 A | 26-05-1971 |
| GB 2163019 | A | 12-02-1986 | NONE | | |
| US 6005446 | A | 21-12-1999 | NONE | | |
| US 4728906 | A | 01-03-1988 | GB | 2181911 A | 29-04-1987 |
| | | | DE | 3686124 D1 | 27-08-1992 |
| | | | DE | 3686124 T2 | 11-03-1993 |
| | | | EP | 0220895 A2 | 06-05-1987 |

EPO FORM P0459